# EUROPEAN PATENT APPLICATION

(11) **EP 4 156 249 A1**
(43) Date of publication of application: **29.03.2023**
(21) Application number: 21808894.6
(22) Date of filing: 11.05.2021
(51) Int. Cl.: H01L 23/36, H01L 23/373, C08K 5/5415, C08K 5/5425, C08K 9/06, C08L 83/06, C08K 3/22

(54) **THERMALLY CONDUCTIVE SILICONE COMPOSITION, PRODUCTION METHOD FOR SAME, AND SEMICONDUCTOR DEVICE**

(30) Priority: 22.05.2020 JP 2020089511
(71) Applicant: SHIN-ETSU CHEMICAL CO., LTD., Tokyo 1000005 (JP)
(72) Inventor: YAMAGUCHI, Takahiro, Annaka-shi, Gunma 379-0224 (JP); UTA, Akira, Annaka-shi, Gunma 379-0224 (JP); SAKAMOTO, Takafumi, Annaka-shi, Gunma 379-0224 (JP)
(74) Representative: Ter Meer Steinmeister & Partner
(86) International application number: PCT/JP2021/017793
(87) International publication number: WO 2021/235259

(57) **Abstract**

This thermally conductive silicone composition contains:
(A) 100 parts by mass of a diorganopolysiloxane which has a hydroxyl group or hydrolyzable group at both terminals of the molecular chain thereof;
(B) 150-600 parts by mass of a hydrolyzable organopolysiloxane which has a specific hydrolyzable silyl group;
(C) 0.1-100 parts by mass of a crosslinking agent component;
(D) 1,500-6,500 parts by mass of zinc oxide particles which have an average particle diameter of 0.1-2 µm and in which, among the particles, the content of coarse grains having a particle diameter of 10 µm or more is 1 vol% or less relative to the total amount of component (D), as measured by the laser diffraction particle size distribution method;
(E) 0.01-30 parts by mass of an adhesion promoter; and
(F) 0.01-20 parts by mass of a pH indicator, wherein the thermal conductivity at 25°C as measured by the hot disk method is 0.5 W/mK or more. The thermally conductive silicone composition has a higher thermal conductivity than the prior art, can be compressed to a thickness of 10 µm or less, and also has high durability; furthermore, the thickening and hardening degree thereof after application in a semiconductor device or the like can be determined.

## Description

### TECHNICAL FIELD

This invention relates to a heat conductive silicone composition. More particularly, it relates to a heat conductive silicone composition for efficiently cooling electronic parts, a method for preparing the composition, and a semiconductor device.

### BACKGROUND ART

It is well known that electronic parts generate heat during operation and concomitantly degrade their performance. A variety of heat dissipating techniques are used to solve the problem. In one common technique, heat dissipation is achieved by disposing a cooling member such as heat sink near a heat generating member, bringing them in close contact, and effectively removing heat from the cooling member. If a gap is left between the heat generating member and the cooling member, less heat conductive air intervenes therebetween, leading to an increase of thermal resistance and failing to fully lower the temperature of the heat generating member. For the purpose of avoiding such a phenomenon, heat dissipating materials having a high thermal conductivity and conformable to the member surface, e.g., heat dissipating fluids and sheets are employed. Particularly in certain devices wherein the gap is as narrow as 10 µm or less, heat dissipating fluids which can be compressed below 10 µm are used. (See Patent Documents 1 to 13: JP 2938428, JP 2938429, JP 3580366, JP 3952184, JP 4572243, JP 4656340, JP 4913874, JP 4917380, JP 4933094, JP-A 2008-260798, JP-A 2009-209165, JP-A 2012-102283, JP-A 2012-096361).

Also, since it is often necessary to establish an electrically insulated state between the heat generating member and the cooling member, the heat conductive material is sometimes required to be insulative. In this situation, metal particles such as aluminum, copper and silver cannot be used as the heat conductive filler, and instead, insulating heat conductive fillers such as aluminum hydroxide and alumina (aluminum oxide) are often used. Since aluminum hydroxide and alumina have a low thermal conductivity in themselves, they must be loaded in large amounts in order to obtain a heat conductive material having high thermal conduction. As a result, the heat conductive material suffers the problems that an extremely high viscosity hinders application, the material cannot be fully compressed, and the heat transfer distance becomes increased. (See Patent Documents 14, 15: JP-A 2017-226724, JP-A 2017-210518)

It is further known that as the heat generating member and the cooling member repeat heat generation and cooling, they experience repeated thermal shrinkage. This helps the heat conductive silicone composition separate into the oily component and the heat conductive filler. In addition, there arises a phenomenon that the heat conductive silicone composition is squeezed out from between the heat generating member and the cooling member, which is known as pump-out. As a result, the thermal resistance increases, failing in efficient cooling of the heat generating member. To prevent such a phenomenon, a technique of adding a thickener to the heat conductive silicone composition to increase its viscosity is proposed. This technique, however, gives rise to the problem that the composition has a very high viscosity and becomes difficult to apply. (See Patent Document 16: JP-A 2004-091743)

Also, in the case wherein a semiconductor devices is filled or coated with a silicone composition which thickens or cures with the aid of airborne moisture under the actual production conditions for the semiconductor device, if it is possible to confirm or judge the thickened or cured state of the composition after the lapse of a certain time without contacting the composition, there are expectable some advantages including improvement in step management and elimination of a storage site of members on the way of assembling. It is thus required to instantly judge the thickened or cured state of a composition applied to a semiconductor device.

### PRIOR ART DOCUMENTS

### PATENT DOCUMENTS

Patent Document 1: JP 2938428
Patent Document 2: JP 2938429
Patent Document 3: JP 3580366
Patent Document 4: JP 3952184
Patent Document 5: JP 4572243
Patent Document 6: JP 4656340
Patent Document 7: JP 4913874
Patent Document 8: JP 4917380
Patent Document 9: JP 4933094
Patent Document 10: JP-A 2008-260798
Patent Document 11: JP-A 2009-209165
Patent Document 12: JP-A 2012-102283
Patent Document 13: JP-A 2012-096361
Patent Document 14: JP-A 2017-226724
Patent Document 15: JP-A 2017-210518
Patent Document 16: JP-A 2004-091743

### SUMMARY OF INVENTION

### TECHNICAL PROBLEM

As discussed above, it is desired to have a heat conductive silicone composition which meets both a high thermal conductivity and compressibility to a thickness of 10 µm or less and has high durability (in terms of power cycling resistance and pump-out resistance). It is also desired to have a heat conductive silicone composition which enables to instantly judge the thickened or cured state of the composition applied (specifically filled or coated) to a semiconductor device or the like, especially whether or not the reaction involved in thickening or curing is completed.

An object of the invention, which has been made under the above-mentioned circumstances, is to provide a heat conductive silicone composition which has a higher thermal conductivity than prior art heat conductive silicone compositions, compressibility to a thickness of 10 µm or less, and high durability, and which enables to visually recognize or judge the thickened or cured state (i.e., the progress of crosslinking reaction) of the composition applied (specifically filled or coated) to a semiconductor device or the like.

### SOLUTION TO PROBLEM

As discussed above, it is desired to have a silicone composition having a high thermal conductivity and satisfactory compressibility to a thickness of 10 µm or less, and to have a silicone composition which experiences a substantial change of its color (specifically, color hue and/or tone) from the initial (i.e., unreacted) color upon reaction with moisture (specifically crosslinking reaction, especially at the completion of crosslinking reaction) and which enables to visually recognize or judge the thickened or cured state of the composition, especially whether or not the reaction involved in thickening or curing is completed.

Making extensive investigations to attain the above objects, the inventors have found that a silicone composition comprising an organopolysiloxane having a hydroxy or hydrolyzable group, a hydrolyzable organopolysiloxane having a specific hydrolyzable silyl group such as alkoxysilyl, a silicon compound having a hydrolyzable silyl group, and zinc oxide having an average particle size in a specific range has a higher thermal conductivity than prior art silicone compositions and can be effectively compressed to a thickness of 10 µm or less; and that when a pH indicator and a basic silane coupling agent are added to the composition, the resulting silicone composition shows a definite color change in accordance with reaction involved in thickening or curing. The present invention is predicated on this finding.

Accordingly, the invention provides a heat conductive silicone composition, a method for preparing the same, and a semiconductor device, as defined below.
[1] A heat conductive silicone composition comprising the following components (A) to (F):
   (A) 100 parts by weight of an organopolysiloxane having the general formula (1) or (2): 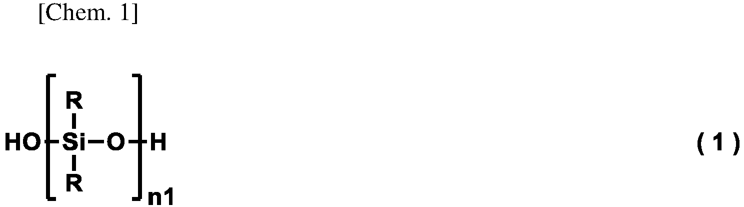 wherein R is independently a C₁-C₂₀ unsubstituted or substituted monovalent hydrocarbon group, and n1 is an integer of at least 10, 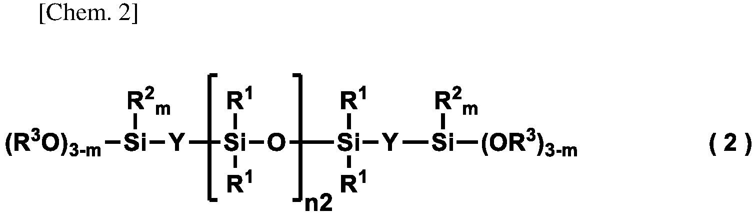 wherein R¹ is independently an unsubstituted or substituted monovalent hydrocarbon group, Y is independently oxygen or a C₁-C₄ alkylene group, R² is independently an unsubstituted or substituted monovalent hydrocarbon group free of aliphatic unsaturation, R³ is independently a C₁-C₄ alkyl, alkoxyalkyl, alkenyl or acyl group, m is an integer of 0 to 2 independently for each of the silicon atoms to which the groups are attached, and n2 is an integer of at least 10,
   (B) 150 to 600 parts by weight of an organopolysiloxane having the general formula (3): 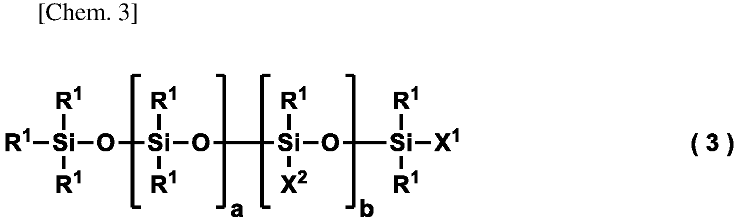 wherein R¹ is independently an unsubstituted or substituted monovalent hydrocarbon group, X¹ is R¹ or a group: -Y-SiR²_{g}(OR³)_{3-g} wherein Y is oxygen or a C₁-C₄ alkylene group, R² is independently an unsubstituted or substituted monovalent hydrocarbon group free of aliphatic unsaturation, R³ is independently a C₁-C₄ alkyl, alkoxyalkyl, alkenyl or acyl group, g is an integer of 0 to 2, X² is independently a group: -Y-SiR²_{g}(OR³)_{3-g} wherein Y, R², R³ and g are as defined for X¹, at least one group: -Y-SiR²_{g}(OR³)_{3-g} being included per molecule, a is an integer of 1 to 1,000, and b is an integer of 0 to 1,000,
   (C) 0.1 to 100 parts by weight of a crosslinking agent in the form of a hydrolyzable organosilane compound containing one methyl, vinyl or phenyl group and at least three hydrolyzable groups per molecule and/or a partial hydrolytic condensate thereof,
   (D) 1,500 to 6,500 parts by weight of particulate zinc oxide having an average particle size of 0.1 to 2 µm, wherein the content of coarse particles having a particle size of at least 10 µm in the laser diffraction particle size distribution is up to 1% by volume based on the total of component (D),
   (E) 0.01 to 30 parts by weight of an adhesion promoter, and
   (F) 0.01 to 20 parts by weight of a pH indicator,
   the composition having a thermal conductivity of at least 0.5 W/mK as measured at 25°C by the hot disk method.
[2] The heat conductive silicone composition of [1] which thickens or cures through airborne moisture-aided crosslinking reaction and the composition shows a color change from the color in the unreacted state when the crosslinking reaction is completed.
[3] The heat conductive silicone composition of [1] or [2] wherein the amount of component (B) is 20 to 40% by volume based on the overall composition, and the composition can be compressed to a thickness of 10 µm or less.
[4] The heat conductive silicone composition of any one of [1] to [3], further comprising (G) 0.01 to 20 parts by weight of a reaction catalyst per 100 parts by weight of component (A).
[5] The heat conductive silicone composition of any one of [1] to [4], further comprising (H) 1 to 1,000 parts by weight of a filler other than component (D) per 100 parts by weight of component (A).
[6] The heat conductive silicone composition of any one of [1] to [5], having a thermal resistance of up to 5 mm²·K/W as measured at 25°C by the laser flash method.
[7] The heat conductive silicone composition of any one of [1] to [6], having an absolute viscosity of 3 to 600 Pa·s as measured by a spiral viscometer at 25°C and a shear rate of 6 s⁻¹.
[8] The heat conductive silicone composition of any one of [1] to [7], which is capable of restraining shifting after the thermal cycling test.
[9] The heat conductive silicone composition of any one of [1] to [8] wherein component (D) is surface-treated with component (B).
[10] The heat conductive silicone composition of any one of [1] to [9] wherein component (E) is a basic silane coupling agent.
[11] The heat conductive silicone composition of any one of [1] to [10] wherein component (F) changes its color in the basic region.
[12] A method for preparing the heat conductive silicone composition of any one of [1] to [11], comprising the step of mixing components (A), (B), (C), (D), (E) and (F).
[13] The method for preparing the heat conductive silicone composition according to [12], comprising the steps of:
   mixing component (B) or components (A) and (B) with component (D) at a temperature of at least 100°C for at least 30 minutes, and
   mixing the mixture with at least components (C), (E) and (F).
[14] A semiconductor device comprising a heat generating member and a cooling member which define a gap having a thickness of up to 10 µm therebetween, wherein the gap is filled with a layer of the heat conductive silicone composition of any one of [1] to [11], and the composition layer thermally intervenes between the heat generating member and the cooling member.
[15] The semiconductor device of [14] wherein the heat generating member is an insulated gate bipolar transistor.

### ADVANTAGEOUS EFFECTS OF INVENTION

The heat conductive silicone composition of the invention has a higher thermal conductivity than prior art heat conductive silicone compositions, is effectively compressed to a thickness of 10 µm or less, and has high durability (in terms of power cycling resistance and pump-out resistance). Since the heat conductive silicone composition shows a color change (from the color in the unreacted state) upon completion of crosslinking reaction, it becomes possible that when the composition is filled in or coated to a semiconductor device or the like and thickens or cures at room temperature with the aid of airborne moisture, a color change of the composition from the color in the unreacted state immediately after application is visually confirmed. It is then readily judged that the crosslinking reaction involved in thickening or curing of the heat conductive silicone composition is completed.

### BRIEF DESCRIPTION OF DRAWINGS

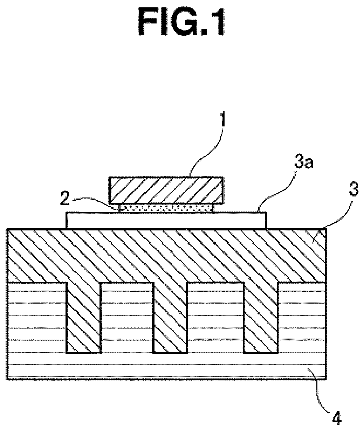

[FIG. 1] FIG. 1 is a cross-sectional view of a semiconductor device including an insulated gate bipolar transistor and a cooling fin wherein the heat conductive silicone composition intervenes in the gap therebetween.

### DESCRIPTION OF EMBODIMENTS

The invention provides a heat conductive silicone composition comprising:
(A) 100 parts by weight of an organopolysiloxane having the general formula (1) or (2): 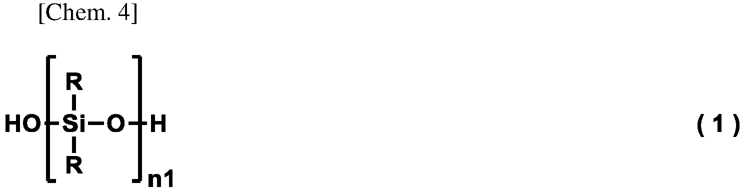 wherein R is independently a C₁-C₂₀ unsubstituted or substituted monovalent hydrocarbon group, and n1 is an integer of at least 10, 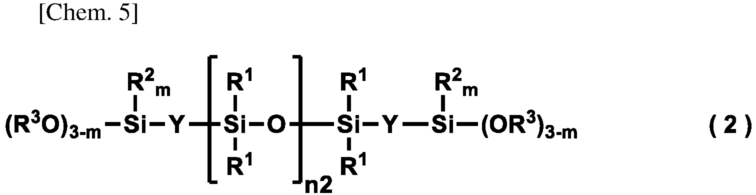 wherein R¹ is independently an unsubstituted or substituted monovalent hydrocarbon group, Y is independently oxygen or a C₁-C₄ alkylene group, R² is independently an unsubstituted or substituted monovalent hydrocarbon group free of aliphatic unsaturation, R³ is independently a C₁-C₄ alkyl, alkoxyalkyl, alkenyl or acyl group, m is an integer of 0 to 2 independently for each of the silicon atoms to which the groups are attached, and n2 is an integer of at least 10,
(B) 150 to 600 parts by weight of an organopolysiloxane having the general formula (3): 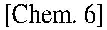 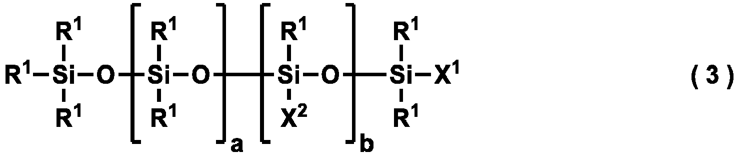 wherein R¹ is independently an unsubstituted or substituted monovalent hydrocarbon group; X¹ is R¹ or a group: -Y-SiR²_{g}(OR³)_{3-g} wherein Y is oxygen or a C₁-C₄ alkylene group, R² is independently an unsubstituted or substituted monovalent hydrocarbon group free of aliphatic unsaturation, R³ is independently a C₁-C₄ alkyl, alkoxyalkyl, alkenyl or acyl group, g is an integer of 0 to 2; X² is independently a group: -Y-SiR²_{g}(OR³)_{3-g} wherein Y, R², R³ and g are as defined for X¹, at least one group: -Y-SiR²_{g}(OR³)_{3-g} being included per molecule; a is an integer of 1 to 1,000, and b is an integer of 0 to 1,000,
(C) 0.1 to 100 parts by weight of a crosslinking agent in the form of a hydrolyzable organosilane compound containing one methyl, vinyl or phenyl group and at least three hydrolyzable groups per molecule and/or a partial hydrolytic condensate thereof,
(D) 1,500 to 6,500 parts by weight of particulate zinc oxide having an average particle size of 0.1 to 2 µm, wherein the content of coarse particles having a particle size of at least 10 µm in the laser diffraction particle size distribution is up to 1% by volume based on the total of component (D),
(E) 0.01 to 30 parts by weight of an adhesion promoter,
(F) 0.01 to 20 parts by weight of a pH indicator, and optionally,
(G) a reaction catalyst,
(H) a filler other than component (D),
the composition having a thermal conductivity of at least 0.5 W/mK as measured at 25°C by the hot disk method. More preferably, the heat conductive silicone composition can be compressed to a thickness of 10 µm or less, thickens or cures through crosslinking reaction with the aid of airborne moisture, and changes its color from that in the unreacted state when the crosslinking reaction is completed. Since the composition changes its color from that in the unreacted state in the course of thickening or curing with the aid of airborne moisture, the completion of reaction involved in thickening or curing is visually recognized or judged.

Now the invention is described in detail.

### - Component (A): Organopolysiloxane -

Component (A) is an organopolysiloxane having the general formula (1). The organopolysiloxane has a structure that it is capped at both ends of the molecular chain with a group having a hydroxy group bonded to a silicon atom, that is, silanol or diorganohydroxysiloxy group. A linear organopolysiloxane of the structure acts as a main component or base polymer in the inventive composition.

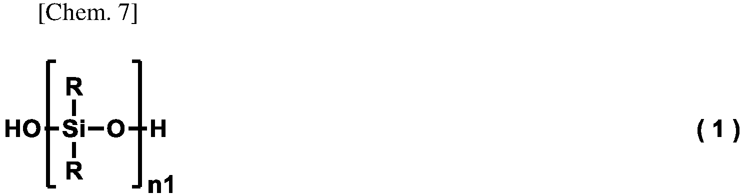

In formula (1), R is a C₁-C₂₀ unsubstituted or substituted monovalent hydrocarbon group, a plurality of R may be the same or different, and n1 is an integer of at least 10.

In formula (1), the number of carbon atoms in the unsubstituted or substituted monovalent hydrocarbon group R is 1 to 20, preferably 1 to 10, more preferably 1 to 8.

Examples of the unsubstituted monovalent hydrocarbon group R include alkyl groups such as methyl, ethyl, n-propyl, isopropyl, n-butyl, isobutyl, tert-butyl, pentyl, neopentyl, hexyl, heptyl, octyl, nonyl, decyl, undecyl, dodecyl, tridecyl, tetradecyl, pentadecyl, hexadecyl, heptadecyl, octadecyl, nonadecyl and eicosyl; cycloalkyl groups such as cyclopentyl and cyclohexyl; alkenyl groups such as vinyl, allyl, propenyl, isopropenyl, butenyl, pentenyl and hexenyl; aryl groups such as phenyl, tolyl, xylyl, α-naphthyl and β-naphthyl; and aralkyl groups such as benzyl, 2-phenylethyl and 3-phenylpropyl. Examples of the substituted monovalent hydrocarbon group R include substituted forms of the foregoing unsubstituted monovalent hydrocarbon groups in which some or all hydrogen atoms are substituted by halogen atoms such as fluorine, bromine or chlorine, cyano or the like, for example, 3-chloropropyl, 3,3,3-trifluoropropyl and 2-cyanoethyl. Of the foregoing unsubstituted and substituted monovalent hydrocarbon groups, R is preferably methyl, ethyl and phenyl, with methyl and phenyl being most preferred in view of availability, productivity and cost.

The organopolysiloxane having formula (1) or formula (2) to be described later as component (A) should preferably have a viscosity at 25°C of 10 to 1,000,000 mPa.s, more preferably 50 to 500,000 mPa·s, even more preferably 100 to 200,000 mPa·s, most preferably 500 to 100,000 mPa. s. An organopolysiloxane having a viscosity of at least 10 mPa·s at 25°C is preferred because a coating film having satisfactory physical and mechanical properties is readily obtained. A viscosity of up to 1,000,000 mPa·s is preferable because the composition avoids an extreme viscosity buildup and is efficient to work with. As used herein, the viscosity is measured by a rotational viscometer unless otherwise stated. Exemplary rotational viscometers include BL, BH, BS and cone plate type viscometers (the same holds true, hereinafter).

The value of n1 in formula (1) designates the number of difunctional diorganosiloxane units in the molecule, or degree of polymerization. In the embodiment wherein the organopolysiloxane as component (A) has a viscosity in the preferred range, the number of difunctional diorganosiloxane units in the molecule or degree of polymerization, represented by n1 in formula (1), is an integer of 10 to 2,000, preferably 50 to 1,800, more preferably 100 to 1,700, most preferably 200 to 1,600. As used herein, the degree of polymerization or molecular weight is a number average degree of polymerization or number average molecular weight as measured by gel permeation chromatography (GPC) versus polystyrene standards using toluene as the developing solvent (the same holds true, hereinafter).

Alternatively, component (A) is an organopolysiloxane having the general formula (2). The organopolysiloxane is a linear organopolysiloxane capped at both ends of the molecular chain with a hydrolyzable silyl group having one to three silicon-bonded organoxy groups. It acts as a main component or base polymer in the inventive composition.

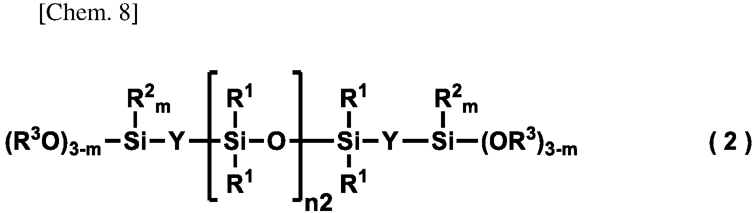

In formula (2), R¹ is independently an unsubstituted or substituted monovalent hydrocarbon group, Y is independently oxygen or a C₁-C₄ alkylene group, R² is independently an unsubstituted or substituted monovalent hydrocarbon group free of aliphatic unsaturation, R³ is independently a C₁-C₄ alkyl, alkoxyalkyl, alkenyl or acyl group, m is an integer of 0 to 2 independently for each of the silicon atoms to which the groups are attached, and n2 is an integer of at least 10.

In formula (2), R¹ is independently an unsubstituted or substituted, preferably C₁-C₁₀, more preferably C₁-C₆, even more preferably C₁-C₃ monovalent hydrocarbon group, examples of which include straight alkyl groups, branched alkyl groups, cycloalkyl groups, alkenyl groups, aryl groups, aralkyl groups, and halogenated alkyl groups. Exemplary straight alkyl groups include methyl, ethyl, propyl, hexyl and octyl. Exemplary branched alkyl groups include isopropyl, isobutyl, tert-butyl and 2-ethylhexyl. Exemplary cycloalkyl groups include cyclopentyl and cyclohexyl. Exemplary alkenyl groups include vinyl and allyl. Exemplary aryl groups include phenyl and tolyl. Exemplary aralkyl groups include 2-phenylethyl and 2-methyl-2-phenylethyl. Exemplary haloalkyl groups include 3,3,3-trifluoropropyl, 2-(nonafluorobutyl)ethyl, and 2-(heptadecafluorooctyl)ethyl. R¹ is preferably methyl, phenyl and vinyl, with methyl being most preferred.

Examples of the C₁-C₄ alkylene group represented by Y include straight alkylene groups such as methylene, ethylene, propylene and butylene, and isomers thereof such as isopropylene and isobutylene. Y is preferably oxygen or ethylene.

R² is independently an unsubstituted or substituted, preferably C₁-C₁₀, more preferably C₁-C₆, even more preferably C₁-C₃ monovalent hydrocarbon group free of aliphatic unsaturation. Examples thereof include alkyl groups such as methyl, ethyl, propyl, isopropyl, butyl, isobutyl, tert-butyl, pentyl, neopentyl, hexyl, heptyl, octyl, nonyl, decyl, and dodecyl; cycloalkyl groups such as cyclopentyl, cyclohexyl and cycloheptyl; aryl groups such as phenyl, tolyl, xylyl, naphthyl and biphenylyl; aralkyl groups such as benzyl, phenylethyl, phenylpropyl and methylbenzyl; and substituted forms of the foregoing groups in which some or all carbon-bonded hydrogen atoms are substituted by halogen atoms such as fluorine, bromine or chlorine, cyano or the like. Of these, methyl is most preferred.

R³ is independently a C₁-C₄ alkyl, alkoxyalkyl, alkenyl or acyl group. Examples of the alkyl group R³ are exemplary C₁-C₄ alkyl groups as exemplified above for R¹. Examples of the alkoxyalkyl group include methoxyethyl and methoxypropyl. Examples of the alkenyl group are exemplary C₁-C₄ alkenyl groups as exemplified above for R¹. Examples of the acyl group R³ include acetyl and propionoxy. R³ is preferably an alkyl group, more preferably methyl and ethyl.

The subscript m is an integer of 0 to 2 independently for each of the silicon atoms to which the groups are attached, preferably 0. The number of OR³ groups per molecule is 1 to 6, preferably 4 or 6.

The value of n2 in formula (2) designates the number of difunctional diorganosiloxane units in the molecule, or degree of polymerization. In the embodiment wherein the organopolysiloxane as component (A) has a viscosity in the preferred range, the number of difunctional diorganosiloxane units in the molecule or degree of polymerization, represented by n2 in formula (2), is an integer of 10 to 2,000, preferably 50 to 1,800, more preferably 100 to 1,700, most preferably 200 to 1,600.

The organopolysiloxane as component (A) may be used alone or in admixture of two or more.

### - Component (B): Organopolysiloxane -

Component (B) is a hydrolyzable organopolysiloxane having a hydrolyzable silyl group, typically alkoxysilyl group at one end and/or side chain (non-end position) of the molecular chain, represented by the general formula (3). Component (B) acts as a surface treating agent (dispersant or wetter) for particulate zinc oxide (heat conductive filler) or component (D), to be described later. Since the interaction between component (B) and particulate zinc oxide as component (D) becomes stronger, the heat conductive silicone composition maintains fluidity even when the composition is filled with a large amount of particulate zinc oxide as component (D), and at the same time, prevents any loss of heat dissipation capability caused by oil separation and pump-out with a lapse of time.

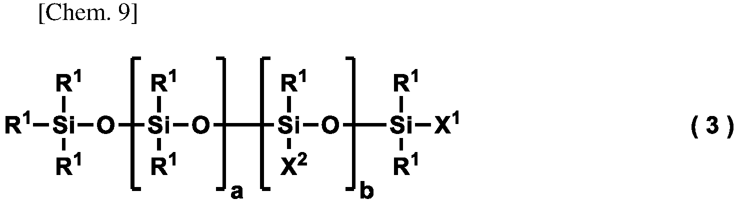

In formula (3), R¹ is independently an unsubstituted or substituted monovalent hydrocarbon group. X¹ is R¹ or a group: -Y-SiR²_{g}(OR³)_{3-g} wherein Y is oxygen or a C₁-C₄ alkylene group, R² is independently an unsubstituted or substituted monovalent hydrocarbon group free of aliphatic unsaturation, R³ is independently a C₁-C₄ alkyl, alkoxyalkyl, alkenyl or acyl group, g is an integer of 0 to 2. X² is independently a group: -Y-SiR²_{g}(OR³)_{3-g} wherein Y, R², R³ and g are as defined for X¹, at least one group: -Y-SiR²_{g}(OR³)_{3-g} being included per molecule. The subscript "a" is an integer of 1 to 1,000, and "b" is an integer of 0 to 1,000.

Like R¹ in formula (2), R¹ in formula (3) is independently an unsubstituted or substituted, preferably C₁-C₁₀, more preferably C₁-C₆, even more preferably C₁-C₃ monovalent hydrocarbon group, examples of which include straight alkyl groups, branched alkyl groups, cycloalkyl groups, alkenyl groups, aryl groups, aralkyl groups, and halogenated alkyl groups. Exemplary straight alkyl groups include methyl, ethyl, propyl, hexyl and octyl. Exemplary branched alkyl groups include isopropyl, isobutyl, tert-butyl and 2-ethylhexyl. Exemplary cycloalkyl groups include cyclopentyl and cyclohexyl. Exemplary alkenyl groups include vinyl and allyl. Exemplary aryl groups include phenyl and tolyl. Exemplary aralkyl groups include 2-phenylethyl and 2-methyl-2-phenylethyl. Exemplary haloalkyl groups include 3,3,3-trifluoropropyl, 2-(nonafluorobutyl)ethyl, and 2-(heptadecafluorooctyl)ethyl. R¹ is preferably methyl, phenyl or vinyl.

Examples of the C₁-C₄ alkylene group represented by Y include straight alkylene groups such as methylene, ethylene, propylene and butylene, and isomers thereof such as isopropylene and isobutylene. Y is preferably oxygen or ethylene.

Like R² in formula (2), R² in formula (3) is independently an unsubstituted or substituted, preferably C₁-C₁₀, more preferably C₁-C₆, even more preferably C₁-C₃ monovalent hydrocarbon group free of aliphatic unsaturation. Examples thereof include alkyl groups such as methyl, ethyl, propyl, isopropyl, butyl, isobutyl, tert-butyl, pentyl, neopentyl, hexyl, heptyl, octyl, nonyl, decyl, and dodecyl; cycloalkyl groups such as cyclopentyl, cyclohexyl and cycloheptyl; aryl groups such as phenyl, tolyl, xylyl, naphthyl and biphenylyl; aralkyl groups such as benzyl, phenylethyl, phenylpropyl and methylbenzyl; and substituted forms of the foregoing groups in which some or all carbon-bonded hydrogen atoms are substituted by halogen atoms such as fluorine, bromine or chlorine, cyano or the like. Of these, methyl is most preferred.

Like R³ in formula (2), R³ in formula (3) is independently a C₁-C₄ alkyl, alkoxyalkyl, alkenyl or acyl group. Examples of the alkyl group R³ are exemplary C₁-C₄ alkyl groups as exemplified above for R¹. Examples of the alkoxyalkyl group include methoxyethyl and methoxypropyl. Examples of the alkenyl group are exemplary C₁-C₄ alkenyl groups as exemplified above for R¹. Examples of the acyl group R³ include acetyl and propionoxy. R³ is preferably an alkyl group, more preferably methyl or ethyl.

The subscripts "a" and "b" are as defined above; a is preferably an integer of 10 to 1,000, more preferably 10 to 300, and b is preferably an integer of 0 to 100, more preferably 0 to 50, most preferably 0. Also, the sum of a+b is preferably 10 to 1,000, more preferably 10 to 300, even more preferably 12 to 100, most preferably 14 to 50. In case of b=0, a is preferably 10 to 1,000, more preferably 10 to 300, even more preferably 12 to 100, most preferably 14 to 50. X¹ is a group: -Y-SiR²_{g}(OR³)_{3-g} wherein Y, R², R³, and g are as defined above. The subscript g is an integer of 0 to 2, preferably 0. The number of OR³ groups per molecule is preferably 1 to 6, most preferably 3. It is noted that the order of arrangement of siloxane units in parentheses is not particularly limited. While the hydrolyzable organopolysiloxane as component (B) is defined as having a hydrolyzable silyl group, typically alkoxysilyl group, at one end and/or side chain (non-end position) of the molecular chain, it preferably has at least a hydrolyzable silyl group at one end of the molecular chain.

Preferred examples of component (B) are shown below.

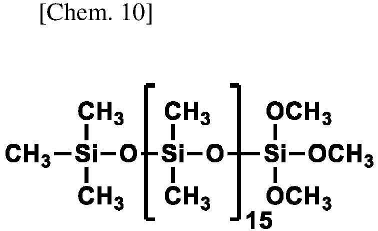

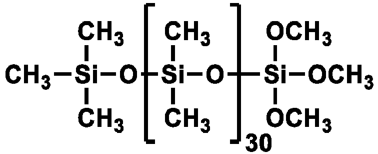

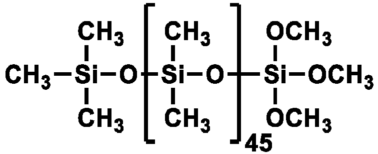

Component (B) is a main component of the silicone matrix in the heat conductive silicone composition, and its amount is 150 to 600 parts by weight, preferably 160 to 500 parts by weight per 100 parts by weight of component (A). Also, the amount of component (B) is preferably 20 to 40% by volume, more preferably 25 to 35% by weight of the overall heat conductive silicone composition. This range of component (B) ensures satisfactory compressibility for the composition and prevents any degradation of thermal resistance caused by oil separation and pump-out.

The amount (% by volume) of component (B) in the overall heat conductive silicone composition is a volume proportion of component (B) in the composition. It is determined by calculating the volume of component (B) from its amount (by weight) and density, calculating the volumes of components in the overall heat conductive silicone composition from their amounts (by weight) and densities, calculating the total of the volumes, and calculating the amount (% by volume) of component (B) in the overall heat conductive silicone composition according to: [volume of component (B)]/[the total of volumes in the overall heat conductive silicone composition]×100%.

Component (B) may be used alone or in admixture of two or more.

### - Component (C): Crosslinking component -

Component (C) is a hydrolyzable organosilane compound containing one methyl, vinyl or phenyl group and at least three hydrolyzable groups per molecule, other than component (B), and/or a partial hydrolytic condensate thereof, that is, an organosiloxane oligomer having at least three residual hydrolyzable groups in the molecule, resulting from partial hydrolysis and condensation of the organosilane compound. The hydrolyzable organosilane compound is represented by the formula: R⁴-SiX₃
wherein R⁴ is a group selected from among methyl, vinyl and phenyl, and X is a hydrolyzable group.

Component (C) serves as a crosslinking agent or chain extender. The condensate serving as component (C) contains no amino group. It is noted that along with the hydrolyzable organosilane compound and/or partial hydrolytic condensate thereof as component (C), there may be used an organosilane compound having two hydrolyzable groups (SiR⁴₂X₂) and/or a partial hydrolytic condensate thereof (that is, an organosiloxane oligomer having at least two residual hydrolyzable groups in the molecule, resulting from partial hydrolysis and condensation of the organosilane compound).

Examples of the hydrolyzable group in component (C) include C₁-C₂₀, preferably C₁-C₁₀, more preferably C₁-C₄ alkoxy groups such as methoxy, ethoxy, propoxy, isopropoxy, butoxy, isobutoxy and tert-butoxy; C₂-C₄₀, preferably C₂-C₁₀, more preferably C₂-C₄ alkoxyalkoxy groups such as methoxymethoxy and methoxyethoxy; C₂-C₂₀, preferably C₂-C₁₀, more preferably C₂-C₅ alkenloxy groups such as vinyloxy, allyloxy, propenoxy and isopropenoxy; C₃-C₂₀, preferably C₃-C₁₀, more preferably C₃-C₆ ketoxime groups such as dimethylketoxime, diethylketoxime and methylethylketoxime; and C₂-C₂₀, preferably C₂-C₁₀, more preferably C₂-C₅ acyloxy groups such as acetoxy.

Examples of component (C) include methyltrimethoxysilane, methyltriethoxysilane, vinyltrimethoxysilane, vinyltriethoxysilane, vinyltriisopropoxysilane, methyltris(methoxyethoxy)silane, vinyltris(methoxyethoxy)silane, methyltripropenoxysilane, vinyltriisopropenoxysilane, phenyltriisopropenoxysilane, methyltriacetoxysilane, vinyltriacetoxysilane, methyltris(methylethylketoxime)silane, and vinyltris(methylethylketoxime)silane, and partial hydrolytic condensates of the foregoing hydrolyzable organosilanes. Notably, component (C) is not limited to the foregoing examples. These compounds may be used alone or in admixture of two or more as component (C).

The amount of component (C) used is 0.1 to 100 parts by weight, preferably 0.1 to 25 parts by weight, more preferably 0.5 to 18 parts by weight per 100 parts by weight of the organopolysiloxane as component (A). If the amount of component (C) used is less than 0.1 part by weight, sufficient crosslinking does not take place, failing to obtain a desired viscous composition. If the amount of component (C) used exceeds 100 parts by weight, the resulting composition has poor physical or mechanical properties and raises the problem of economic disadvantage.

### - Component (D): Particulate zinc oxide -

The heat conductive silicone composition of the invention contains (D) particulate zinc oxide as a heat conductive filler. Zinc oxide has a high thermal conductivity comparable to metal oxides such as aluminum oxide and magnesium oxide. This means that a heat conductive silicone composition having a relatively high thermal conductivity is available as long as the composition can be filled with a necessary sufficient amount of zinc oxide. The particulate zinc oxide as component (D) should have an average particle size of from 0.1 µm to 2 µm, preferably from 0.2 µm to 1.5 µm. If the average particle size of particulate zinc oxide as component (D) exceeds 2 µm, the resulting heat conductive silicone composition is substantially aggravated in compressibility. If the average particle size of particulate zinc oxide as component (D) is less than 0.1 µm, the resulting heat conductive silicone composition shows a substantial viscosity buildup.

The average particle size is a volume basis average particle size or accumulative average particle size D50 (or median diameter) as measured by a particle size analyzer of the laser diffraction scattering method, for example, Microtrac MT3300EX (Nikkiso Co., Ltd.) (the same holds true, hereinafter).

In component (D), the content (or percent proportion) of coarse particles having a particle size of at least 10 µm in the laser diffraction particle size distribution is up to 1% by volume based on the total of component (D). If the content of coarse particles exceeds 1% by volume, the resulting heat conductive silicone composition cannot be compressed to a thickness of 10 µm or less. Such a content of coarse particles is preferably reached by previous classification treatment on prior art well-known means. Alternatively, particulate zinc oxide having such a content of coarse particles is commercially available as zinc oxide of grade 1, 2 or 3.

The content of coarse particles is readily determined from the measurement of the particle size distribution of overall component (D) by a particle size analyzer of the laser diffraction scattering method, for example, Microtrac MT3300EX (Nikkiso Co., Ltd.) (the same holds true, hereinafter).

The heat conductive silicone composition contains 1,500 to 6,500 parts by weight, preferably 2,000 to 6,000 parts by weight of particulate zinc oxide as component (D) per 100 parts by weight of component (A). Also, the heat conductive silicone composition preferably contains 45 to 70% by volume, more preferably 55 to 65% by volume of component (D) based on the overall composition. If the amount of particulate zinc oxide as component (D) is less than 1,500 parts by weight or less than 45% by volume, the heat conductive silicone composition has a low thermal conductivity. If the amount of particulate zinc oxide is more than 6,500 parts by weight or more than 70% by volume, the heat conductive silicone composition fails to be uniform.

The amount (% by volume) of particulate zinc oxide as component (D) in the overall heat conductive silicone composition is a volume proportion in the composition. The amount (% by volume) of component (D) based on the overall heat conductive silicone composition can be determined by calculating the volume of component (D) from its amount (weight) and density, calculating the volumes of components in the overall heat conductive silicone composition from their amounts (weight) and densities, calculating the total of the volumes, and calculating the amount (% by volume) of component (D) based on the overall heat conductive silicone composition according to: (volume of component (D))/[total of volumes in the overall heat conductive silicone composition]×100%.

It is noted that in the preferred heat conductive silicone composition, component (D) has been surface-treated with component (B).

### - Component (E): Adhesion promoter -

Component (E) is an adhesion promoter which is used in order to impart necessary pressure-sensitive adhesiveness to the heat conductive silicone composition. As the adhesion promoter or component (E), any well-known silane coupling agents (exclusive of component (C)) are preferably used. Suitable silane coupling agents include carbon functional group-containing hydrolyzable silanes (so-called carbon-functional silanes). Examples thereof include (meth)acrylic silane coupling agents, epoxy silane coupling agents, amino silane coupling agents (exclusive of guanidyl group-containing hydrolyzable silane compounds), mercapto silane coupling agents, and isocyanate silane coupling agents.

Examples include γ-methacryloxypropyltrimethoxysilane; β-(3,4-epoxycyclohexyl)ethyltrimethoxysilane, γ-glycidoxypropyltrimethoxysilane, γ-glycidoxypropylmethyldiethoxysilane; aminoalkyl-substituted alkoxysilanes such as 3-aminopropyltriethoxysilane and N-β-(aminoethyl)-γ-aminopropyltrimethoxysilane; γ-mercaptopropyltrimethoxysilane, isocyanate silanes, and compounds obtained from partial hydrolysis and condensation of the foregoing.

Of these examples of component (E), basic silane coupling agents are preferred. Inter alia, epoxy silanes such as γ-glycidoxypropyltrimethoxysilane and β-(3,4-epoxycyclohexyl)ethyltrimethoxysilane; amino silanes such as 3-aminopropyltriethoxysilane and N-β-(aminoethyl)-γ-aminopropyltrimethoxysilane; and isocyanate silanes are preferred. Amino silanes such as 3-aminopropyltriethoxysilane and N-β-(aminoethyl)-γ-aminopropyltrimethoxysilane and isocyanate silanes are more preferred. Amino silanes such as 3-aminopropyltriethoxysilane and N-β-(aminoethyl)-γ-aminopropyltrimethoxysilane are even more preferred. Aminoalkyltriethoxysilanes such as 3-aminopropyltriethoxysilane are most preferred.

The amount of component (E) is 0.01 to 30 parts by weight, preferably 0.1 to 20 parts by weight per 100 parts by weight of component (A). If the amount of component (E) is too small or less than 0.01 part by weight, it fails to impart sufficient pressure-sensitive adhesiveness to the inventive composition. If the amount of component (E) exceeds 30 parts by weight, the resulting composition has poor physical or mechanical properties and raises the problem of economic disadvantage.

### - Component (F): pH indicator -

Component (F) in the heat conductive silicone composition is a pH indicator which shows a color change with a pH change, preferably in the basic region. Component (F), when used in combination with the adhesive promoter (silane coupling agent) as component (E), especially basic silane coupling agent such as the above-exemplified amino silane coupling agent, aims to impart a discoloration function by utilizing a pH change of the composition in association with the progress of thickening or curing reaction of the composition as a result of adsorption of airborne moisture.

Any of commonly used pH indicators may be used as component (F). Examples of component (F) include phenolphthalein, thymolphthalein, Alizarine Yellow R, cresolphthalein, Cresol Red, Phenol Red, and Bromothymol Blue, which may be used alone or in admixture of two or more.

The amount of component (F) is 0.01 to 20 parts by weight, preferably 0.1 to 9 parts by weight, more preferably 1 to 6 parts by weight per 100 parts by weight of component (A). If the amount of component (F) is less than the lower limit of 0.01 part by weight, there is a risk of failing to obtain a sufficient color change. If the amount of component (F) exceeds the upper limit of 20 parts by weight, there is a risk that the pH indicator precipitates on the surface of the heat conductive silicone composition or the composition degrades its outer appearance.

### - Component (G): Reaction catalyst -

The reaction catalyst as component (G) is an optional component which may be blended if necessary. The reaction catalyst as component (G) may be selected from non-metal-base organic catalysts and metal-base catalysts. Component (G) has the function of promoting the cure or viscosity buildup of the heat conductive silicone composition.

Of the reaction catalysts as component (G), the non-metal-base organic catalyst may be selected from those well known as the agent for promoting the cure or viscosity buildup of heat conductive silicone compositions, though is not particularly limited. Examples include phosphazene-containing compounds such as N,N,N',N',N",N"-hexamethyl-N"'-(trimethylsilylmethyl)-phosphorimidic triamide; amine compounds or salts thereof such as hexylamine and dodecylamine phosphate; quaternary ammonium salts such as benzyltriethylammonium acetate; dialkylhydroxylamines such as dimethylhydroxylamine and diethylhydroxylamine; guanidyl-containing silanes and siloxanes such as N,N,N',N'-tetramethylguanidylpropyltrimethoxysilane, N,N,N',N'-tetramethylguanidylpropylmethyldimethoxysilane, and N,N,N',N'-tetramethylguanidylpropyltris(trimethylsiloxy)silane. The non-metal-base organic catalysts may be used alone or in admixture.

Of the reaction catalysts as component (G), the metal-base organic catalyst may be selected from those well known as the agent for promoting the cure or viscosity buildup of heat conductive silicone compositions, though is not particularly limited. Examples include alkyl tin ester compounds such as dibutyltin diacetate, dibutyltin dilaurate, dibutyltin dioctoate, dioctyltin dineodecanoate, and di-n-butyldimethoxytin; titanates and titanium chelate compounds such as tetraisopropoxytitanium, tetra-n-butoxytitanium, tetrakis(2-ethylhexoxy)titanium, dipropoxybis(acetylacetonato)titanium, and titanium isopropoxyoctylene glycol; zinc naphthenate, zinc stearate and zinc 2-ethyloctoate; alcolate aluminum compounds such as aluminum isopropylate and aluminum sec-butylate; aluminum chelate compounds such as aluminum alkylacetate diisopropylate and aluminum bisethylacetoacetate monoacetylacetonate; organo-metal compounds such as bismuth(III) neodecanoate, bismuth(III) 2-ethylhexanoate, bismuth(III) citrate, bismuth octylate, iron 2-ethylhexoate, cobalt 2-ethylhexoate, manganese 2-ethylhexoate, and cobalt naphthenate; lower fatty acid salts of alkali metals such as potassium acetate, sodium acetate and lithium oxalate. The metal-base organic catalyst is not limited thereto and may be used alone or in admixture.

The amount of component (G) blended may be a small catalytic amount. When used, the amount of the reaction catalyst added as component (G) is preferably 0.01 to 20 parts by weight, more preferably 0.05 to 10 parts by weight, even more preferably 0.05 to 5 parts by weight per 100 parts by weight of component (A). If the amount of component (G) is less than 0.01 part by weight, no satisfactory curing reaction or viscosity buildup takes place, causing the inconvenience of retarded reaction rate. If the amount of component (G) exceeds 20 parts by weight, the reaction rate of the composition becomes too high, with the risk that the working time of the composition after coating is short.

### - Component (H): Filler -

The filler as component (H) is an optional component which may be blended if necessary. Component (H) encompasses fillers (inorganic fillers and organic resin fillers) other than the particulate zinc oxide as component (D) and is used in order to impart sufficient mechanical strength to the composition. Any well-known fillers may be used as component (H). Examples of the filler which can be used herein include silicas such as finely divided silica, fumed silica, precipitated silica, and those silicas whose surface is subjected to hydrophobic treatment with organosilicon compounds; glass beads; glass balloons; transparent resin beads; silica aerogel; metal oxides such as diatomaceous earth, iron oxide, titanium oxide, and fumed metal oxides; wet silica or wet silica whose surface is subjected to silane treatment; reinforcements such as quartz powder, talc, zeolite and bentonite; asbestos, glass fibers, carbon fibers; metal carbonates such as calcium carbonate, magnesium carbonate, and zinc carbonate; glass wool, finely divided mica, fused silica powder; powdered synthetic resins such as polystyrene, polyvinyl chloride, and polypropylene. Of the above-exemplified fillers, inorganic fillers such as silica, calcium carbonate and zeolite are preferred, and fumed silica whose surface is subjected to hydrophobic treatment and calcium carbonate are more preferred. It is noted that the zinc oxide having a specific average particle size defined as component (D) is excluded from the filler as component (H).

When used, the amount of component (H) is preferably 1 to 1,000 parts by weight, more preferably 3 to 500 parts by weight, even more preferably 5 to 300 parts by weight per 100 parts by weight of component (A). If component (H) is used in an amount of more than 1,000 parts by weight, the composition increases its viscosity to adversely affect working. If the amount of component (H) is less than 1 part by weight, the resulting composition fails to increase its mechanical strength sufficiently. The filler as component (H) should preferably have an average particle size of from 0.005 µm (5 nm) to 2 µm, more preferably from 0.01 µm to 1.5 µm. Like the particulate zinc oxide as component (D), it is preferred for the filler as component (H) that the content of coarse particles having a particle size of at least 10 µm in the laser diffraction particle size distribution is up to 1% by volume based on the total of component (H). If the content of coarse particles in component (H) exceeds 1% by volume, it is sometimes difficult that the heat conductive silicone composition is compressed to a thickness of 10 µm or less.

### - Another component: Organopolysiloxane -

In addition to components (A) to (H), the heat conductive silicone composition of the invention may further comprise (I) a linear diorganopolysiloxane (so-called non-functional silicone oil) having the general formula (4) as an optional component if necessary.

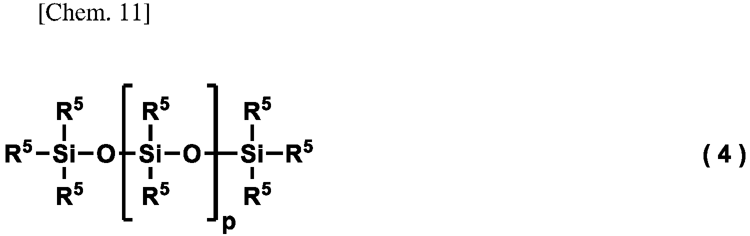

In formula (4), R⁵ is hydrogen or a C₁-C₂₀ monovalent hydrocarbon group free of aliphatic unsaturation which may have a substituent, and p is an integer of 1 to 2,000.

In formula (4), R⁵ is an unsubstituted or substituted, C₁-C₂₀, preferably C₁-C₁₀, more preferably C₁-C₈ monovalent hydrocarbon group free of aliphatic unsaturation. A plurality of R⁵ may be the same or different. Examples of the unsubstituted monovalent hydrocarbon group R⁵ in formula (4) include alkyl groups such as methyl, ethyl, n-propyl, isopropyl, n-butyl, isobutyl, tert-butyl, pentyl, neopentyl, hexyl, heptyl, octyl, nonyl, decyl, undecyl, dodecyl, tridecyl, tetradecyl, pentadecyl, hexadecyl, heptadecyl, octadecyl, nonadecyl and eicosyl; cycloalkyl groups such as cyclopentyl and cyclohexyl; aryl groups such as phenyl, tolyl, xylyl, α-naphthyl and β-naphthyl; aralkyl groups such as benzyl, 2-phenylethyl, and 3-phenylpropyl. Examples of the substituted monovalent hydrocarbon group include substituted forms of the foregoing unsubstituted monovalent hydrocarbon groups in which some or all hydrogen atoms are substituted by halogen atoms such as fluorine, bromine or chlorine, cyano or the like, such as 3-chloropropyl, 3,3,3-trifluoropropyl, and 2-cyanoethyl. Of these, methyl, ethyl and phenyl are preferred, and methyl and phenyl are more preferred in view of availability, productivity and cost. It is especially preferred that all R⁵ in formula (4) be methyl. Most preferred is dimethylpolysiloxane which is capped at both ends of the molecular chain with a trimethylsiloxy group.

In formula (4), p which designates the degree of polymerization of component (I) is an integer of 1 to 2,000, preferably 2 to 2,000, more preferably 20 to 2,000. When the value of p is in the range, the diorganopolysiloxane as component (I) has a viscosity at 25°C of 1.5 to 1,000,000 mPa·s, preferably 30 to 100,000 mPa. s.

When used, the amount of component (I) blended is preferably 0.01 to 100 parts by weight, more preferably 10 to 80 parts by weight per 100 parts by weight of component (A). An amount of component (I) within the range is preferable because the heat conductive silicone composition is not degraded in mechanical properties and flame retardance. Also the composition may be adjusted to such a modulus of elasticity and viscosity that the composition is easy to apply and handle.

### [Other components]

In the heat conductive silicone composition, any well-known antioxidants such as 2,6-di-tert-butyl-4-methylphenol may be blended, if necessary, for preventing the composition from degrading. Also, a thixotropic agent, dye, pigment, flame retardant, anti-settling agent or the like may be blended, if necessary.

### [Physical properties of silicone composition]

The heat conductive silicone composition of the invention has a higher thermal conductivity than prior art heat conductive silicone compositions and satisfactory compressibility to a thickness of 10 µm or less.

The heat conductive silicone composition should have a thermal conductivity of at least 0.5 W/mK, preferably at least 1.3 W/mK as measured at 25°C by the hot disk method. For the detail of the measurement of thermal conductivity, reference is made to the method in Examples to be described later.

The heat conductive silicone composition of the invention has satisfactory compressibility. When compressed under a pressure of 4.1 MPa for 2 minutes, the thickness of the heat conductive silicone composition reaches 10 µm or less, preferably in the range of 0.5 to 10 µm, more preferably in the range of 0.5 to 5 µm. For the detail of measurement of thickness after compression, reference is made to the method in Examples to be described later.

Since the heat conductive silicone composition has both high thermal conductivity and satisfactory compressibility, it has a low thermal resistance. The heat conductive silicone composition preferably has a thermal resistance of up to 5 mm²·K/W, more preferably up to 3 mm²·K/W, as measured at 25°C by the laser flash method. The lower limit is not critical and may be 0.1 mm²·K/W, for example, due to physical problems. As long as the thermal resistance is equal to or less than the specific value, the heat conductive silicone composition has a more increased thermal conductivity. For the detail of the measurement of thermal resistance, reference is made to the method in Examples to be described later.

The heat conductive silicone composition should preferably have an absolute viscosity of 3 to 600 Pa·s, more preferably 10 to 600 Pa·s as measured at 25°C by a spiral viscometer. An absolute viscosity of at least 3 Pa·s ensures ease of shape retention and working efficiency. On the other hand, an absolute viscosity of up to 600 Pa·s ensures smooth discharge and working efficiency. The absolute viscosity can be adjusted by blending of the foregoing components. As used herein, the absolute viscosity is measured, for example, by a spiral viscometer of Malcom Co., Ltd. at 25°C and a shear rate of 6 s⁻¹.

The mechanism that the heat conductive silicone composition undergoes a color change as a result of thickening and curing relies on the discoloration of a pH indicator. The heat conductive silicone composition puts forward thickening and curing due to the progress of condensation reaction (crosslinking reaction) with the aid of airborne moisture (water). When the composition is to be stored in the unreacted state, it is stored in the state shut off from air (ambient air). When the composition is exposed to moisture (water)-containing air at the start of condensation reaction, the pH indicator and the silane coupling agent having a specific acidity or basicity are included (or co-exist) in the composition. Then, the composition adsorbs airborne moisture (water) from its surface, and the adsorbed moisture (water) infiltrates into the matrix of the composition (or cured product). If an effective amount of water is present in the matrix of the composition (or cured product) at this point, a pH change occurs due to the coexistence of the water and the silane coupling agent and invites a color change. However, in the composition of moisture-aided thickening and curing type, before the start of condensation reaction and/or in the course of reaction (before the completion of reaction), the airborne water infiltrating from the surface of the composition into the matrix of the composition is preferentially consumed by the curing reaction (condensation reaction) of the composition until the completion of reaction of the composition. This means that effective water to contribute to the color development of the pH indicator is not available in the matrix of the composition. Then no color change occurs until the completion of reaction, and color development takes place at or subsequent to the completion of reaction. That is, the heat conductive silicone composition maintains the color (color hue and/or tone) of the composition itself (normally, when the filler such as inorganic filler is contained, white color due to the presence of the filler or the hue of the filler itself other than white color), without the influence of the color development of the pH indicator, from the unreacted state to the completion of reaction. Then the composition (or cured product) changes its color to the color corresponding to the color development of the pH indicator at or subsequent to the completion of reaction. Therefore, the color change mechanism of the invention allows for a more definite visual recognition or judgment between the unreacted state and the reacted (thickened or cured) state, as compared with the prior art.

### [Method for preparing heat conductive silicone composition]

Another embodiment of the invention is a method for preparing the heat conductive silicone composition, which is described below.

The method for preparing a heat conductive silicone composition is a method for preparing the heat conductive silicone composition defined herein, which involves the step of mixing components (A), (B), (C), (D), (E), and (F).

The method preferably involves the step of mixing component (B) or components (A) and (B) with component (D) at a temperature of at least 100°C, preferably 150 to 250°C, for at least 30 minutes, preferably from 40 minutes to 6 hours.

Specifically, the method involves the step of mixing component (B) or components (A) and (B) with component (D) as described above and the step of mixing the mixture with at least components (C), (E) and (F) and other optional components, if necessary.

That is, components (B) and (D), or components (A), (B) and (D) are previously mixed under reduced pressure, and mixing is continued at an elevated temperature, for example, 100 to 160°C for 30 minutes to 3 hours. Subsequently, components (C), (E) and (F) and other optional components are blended with the mixture, and mixing is continued under atmospheric pressure or a reduced pressure, preferably a reduced pressure of 0.09 to 0.01 MPa. Mixing is continued without heating, preferably at or below 60°C, typically for 30 minutes to 3 hours, obtaining the inventive composition.

The mixer used herein is not particularly limited. There may be used a mixer, for example, Trimix, Twin Mix, Planetary Mixer (trade names of mixers by Inoue Mfg., Inc.), Ultra Mixer (trade name of mixer by Mizuho Industrial Co., Ltd.) or Hivis Disper Mix (trade name of mixer by Primix Corp.). This may be followed by finishing treatment on a three-roll mill in order to disintegrate aggregates of particulate zinc oxide as heat conductive filler (D).

The preparation method described above yields the heat conductive silicone composition having a higher thermal conductivity than prior art heat conductive silicone compositions and satisfactory compressibility to a thickness of 10 µm or less.

In the duration when component (B) or components (A) and (B) are mixed with component (D) at a temperature of at least 100°C for at least 30 minutes, component (D) is fully surface-treated with component (B) for thereby preventing the thermal resistance from degrading with a lapse of time.

Another exemplary method for preparing the heat conductive silicone composition involves the steps of mixing components (A), (B), (C), (D), (E) and (F) under atmospheric pressure or reduced pressure, preferably a reduced pressure of 0.09 to 0.01 MPa, and further mixing the mixture without heating, preferably at or below 60°C, typically for 30 minutes to 3 hours. When components other than components (A), (B), (C), (D), (E) and (F) are blended in this method, they may be blended at the start of mixing of components (A), (B), (C), (D), (E) and (F) under atmospheric pressure or reduced pressure.

### [Semiconductor device]

A further embodiment of the invention is a semiconductor device comprising a heat generating member, typically an insulated gate bipolar transistor and a cooling member, which define a gap having a thickness of up to 10 µm therebetween, wherein the gap is filled with a layer of the heat conductive silicone composition defined above, and the composition layer thermally intervenes between the heat generating member and the cooling member. The heat conductive silicone composition is compressed to a thickness of 10 µm or less. A significant improvement in cooling efficiency is expectable as compared with prior art heat conductive silicone compositions.

A typical structure is illustrated by the cross-sectional view of FIG. 1 although the invention is not limited thereto.

FIG. 1 illustrates the semiconductor device comprising a heat generating member 1 and a cooling member 3, which define a gap therebetween, wherein a layer 2 of the heat conductive silicone composition intervenes in the gap. Notably, the cooling member 3 has an insulating layer 3a disposed on the surface in contact with the heat conductive silicone composition layer 2.

The heat generating member 1 is preferably an insulated gate bipolar transistor (IGBT). The semiconductor device wherein the heat generating member 1 is IGBT has the advantage that the IGBT is efficiently cooled.

The cooling member 3 is preferably a cooling fin (consisting of a plate and heat-dissipating protrusions disposed on one major surface of the plate) of fully heat conductive material.

The insulating layer 3a is a thin film having a thickness of 10 to 1,000 µm which is formed on the surface (cooling fin plate) of the cooling member (cooling fin) 3 on which the heat conductive silicone composition layer 2 is disposed and made of fully heat conductive insulating material such as silicon nitride, aluminum nitride or diamond.

The heat conductive silicone composition layer 2 is formed by applying the heat conductive silicone composition to the gap between the back side of the heat generating member (IGBT) 1 and the plate side of the cooling member (cooling fin) 3 in a layer form. The heat conductive silicone composition layer 2 has a thickness of up to 10 µm, preferably in the range of 0.5 to 10 µm, more preferably 0.5 to 5 µm.

By constructing the semiconductor device as described above, the heat generated from the heat generating member 1 is conducted to the cooling member 3 via the heat conductive silicone composition layer 2 and released outside, specifically in the case of FIG. 1, to cooling water 4 in contact with the cooling member 3.

Although a method for manufacturing the semiconductor device is not particularly limited, assembling is performed under a pressure of preferably at least 0.1 MPa, more preferably at least 4.0 MPa so that the heat conductive silicone composition may have a thickness of up to 10 µm. By increasing the pressure under which the heat conductive silicone composition is compressed, the time taken for compression can be reduced.

Now that the heat conductive silicone composition layer 2 formed in the gap between the back side of the heat generating member (IGBT) 1 and the plate side of the cooling member (cooling fin) 3 in a layer form undergoes a color change after a certain time after filling, the completion of thickening or curing reaction is recognized and judged by the color change without contacting the composition. At this point, it is preferred that the heat conductive silicone composition layer 2 is formed such that part thereof is projected from the gap, or a sample obtained by applying the heat conductive silicone composition onto a separate plate is simultaneously held in the same environment. This is because a color change associated with the completion of reaction of the composition layer 2 after filling is readily recognized.

The heat conductive silicone composition is useful as an insulating material or adhesive for electric and electronic parts in that the composition causes no contact failures to electric and electronic parts.

### EXAMPLES

Examples and Comparative Examples are given below for further illustrating the invention although the invention is not limited thereto. It is noted that the average particle size of particulate zinc oxide (D) and the content (% by volume) of coarse particles having a particle size of at least 10 µm in component (D) are measured in accordance with the laser diffractometry particle size distribution measurement method (laser diffraction scattering method), using Microtrac MT3300EX (Nikkiso Co., Ltd.).

The components used herein are identified below.

### [Component (A)]

- (A-1): dimethylpolysiloxane capped at both ends of the molecular chain with hydroxy and having a viscosity of 700 mPa.s at 25°C (n1=~268 in formula (1))
- (A-2): dimethylpolysiloxane capped at both ends of the molecular chain with hydroxy and having a viscosity of 20,000 mPa·s at 25°C (n1=~615 in formula (1))
- (A-3): dimethylpolysiloxane capped at both ends of the molecular chain with hydroxy and having a viscosity of 50,000 mPa·s at 25°C (n1=~886 in formula (1))
- (A-4): dimethylpolysiloxane capped at both ends of the molecular chain with hydroxy and having a viscosity of 100,000 mPa-s at 25°C (n1=~1,589 in formula (1))
- (A-5): dimethylpolysiloxane capped at both ends of the molecular chain with trimethoxysilyl and having a viscosity of 900 mPa·s, represented by the following formula (2-1), which corresponds to formula (2) wherein R¹=R³=methyl, Y=O, m=0, and n2=285.

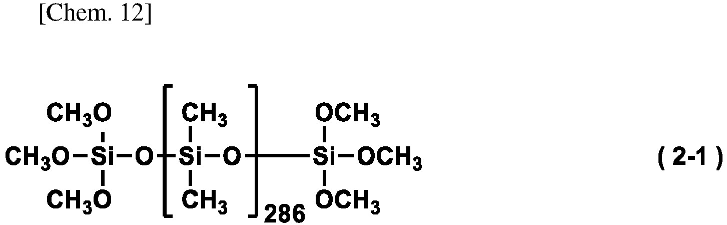

### [Component (B)]

- (B-1): dimethylpolysiloxane capped at one end with trimethoxysilyl, represented by the following formula 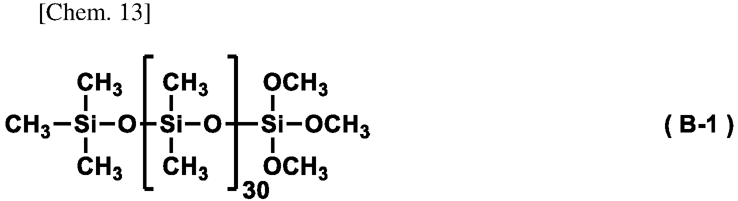
- (B-2): dimethylpolysiloxane capped at one end with trimethoxysilyl, represented by the following formula 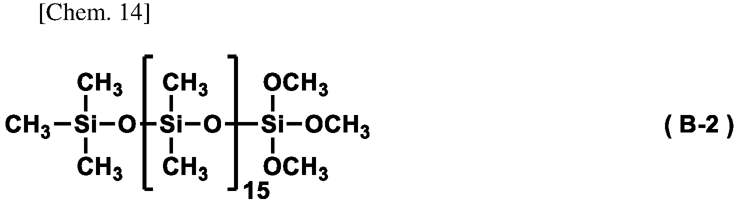
- (B-3): dimethylpolysiloxane capped at one end with trimethoxysilyl, represented by the following formula 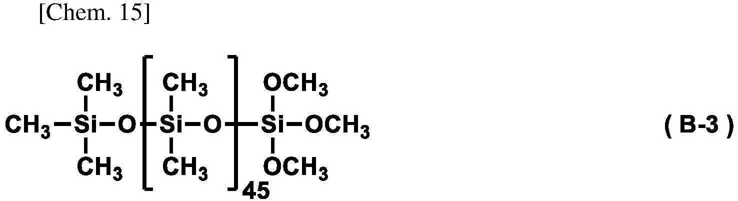
- (B'): dimethylpolysiloxane free of hydrolyzable group, represented by the following formula (comparison)

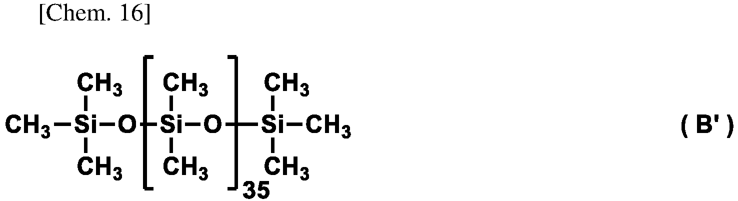

### [Component (C)]

- (C-1): phenyltriisopropenoxysilane
- (C-2): vinyltriisopropenoxysilane
- (C-3): methyltrimethoxysilane

### [Component (D)]

- (D-1): zinc oxide powder having an average particle size of 1.0 µm and containing up to 0.1% by volume of coarse particles of 10 µm or larger
- (D-2): zinc oxide powder having an average particle size of 40.0 µm and containing at least 80% by volume of coarse particles of 10 µm or larger (comparison)

### [Component (E)]

- (E-1): 3-aminopropyltriethoxysilane

### [Component (F)]

- (F-1): phenolphthalein
- (F-2): thymolphthalein

### [Component (G)]

- (G): N,N,N' ,N' -tetramethylguanidylpropyltrimethoxysilane

### [Component (H)]

- (H): dry silica having a BET specific surface area of 130 m²/g (average particle size ~15 nm, content of coarse particles of 10 µm or larger < 0.1% by volume)

### [Examples 1 to 22 and Comparative Examples 1 to 5]

### <Preparation of heat conductive silicone composition>

Heat conductive silicone compositions were prepared by blending components (A) to (H) in the amounts shown in Tables 1 to 6 according to the following procedure.

On a 5-L planetary mixer (Inoue Mfg., Inc.), components (A), (B) and (D) were fed and mixed at 170°C for 1 hour. The mixture was cooled to room temperature, to which components (C), (E) and (F) were added and mixed until uniform, obtaining a heat conductive silicone composition.

Further, components (G) and (H) were added if necessary and mixed to form a heat conductive silicone composition.

Each of the heat conductive silicone compositions prepared by the above procedure was measured for absolute viscosity, thermal conductivity, compressibility, thermal resistance, thermal resistance after thermal cycling, and a change of appearance color (or hue) by the following methods. The results are also shown in Tables 1 to 6.

### [Absolute viscosity]

The absolute viscosity of each heat conductive silicone composition was measured using a spiral viscometer (Malcom Co., Ltd.) at 25°C and a revolution or shear rate of 6 s⁻¹.

### [Thermal conductivity]

A sample was prepared by wrapping each heat conductive silicone composition with kitchen wrapping film into a pouch shape, and measured for thermal conductivity at 25°C by the hot disk method using a meter TPA-501 (Kyoto Electronics Mfg. Co., Ltd.).

### [Compressibility]

Using autograph AG-5KNZ Plus (Shimadzu Corp.), each heat conductive silicone composition sandwiched between a pair of silicon wafers in the form of a disk with diameter 1 mm was compressed under 4.1 MPa for 2 minutes, after which a minimum thickness was measured. The minimum thickness of the heat conductive silicone composition was determined by furnishing two metal plates (silicon wafers), compressing the two metal plates in direct contact, measuring the total thickness of the compressed two metal plates as an initial value, sandwiching the heat conductive silicone composition between the metal plates (silicon wafers) after the measurement of the initial value, compressing the sample, measuring the thickness of the compressed sample, and subtracting the initial value (the total thickness of two metal plates) from the measured thickness.

### [Thermal resistance]

The above sample (sample as compressed in "compressibility" test, i.e., sandwich of heat conductive silicone composition between two silicon wafers) was measured for thermal resistance at 25°C by a thermal resistance meter (xenon flash analyzer LFA447 NanoFlash by Netzsch) based on the laser flash method.

### [Thermal resistance after thermal cycling]

Using a thermal shock chamber TSE-11A (Espec Corp.), the above sample (sample as compressed in "compressibility" test, i.e., sandwich of heat conductive silicone composition between two silicon wafers) was subjected to a thermal cycling test of repeating 1,000 cycles of holding at -40°C for 30 minute and holding at 150°C for 30 minutes. Thereafter, a thermal resistance was measured at 25°C by a thermal resistance meter (xenon flash analyzer LFA447 NanoFlash by Netzsch) based on the laser flash method.

### [Change of appearance color]

Each heat conductive silicone composition was cast into a mold and shaped into a sheet of 2 mm thick. The color hue (initial) of the sheet as molded and the color hue (after 5 days) of the sheet held in an atmosphere of 23±2°C and 50±5% RH for 5 days were visually evaluated, from which a color change was recognized. It is noted that a thickening (i.e., viscosity buildup) was recognized when a sheet was allowed to stand in an atmosphere of 23±2°C and 50±5% RH for 5 days, but neither viscosity change nor color change was recognized when the sample was then allowed to stand in an atmosphere of 23±2°C and 50±5% RH.

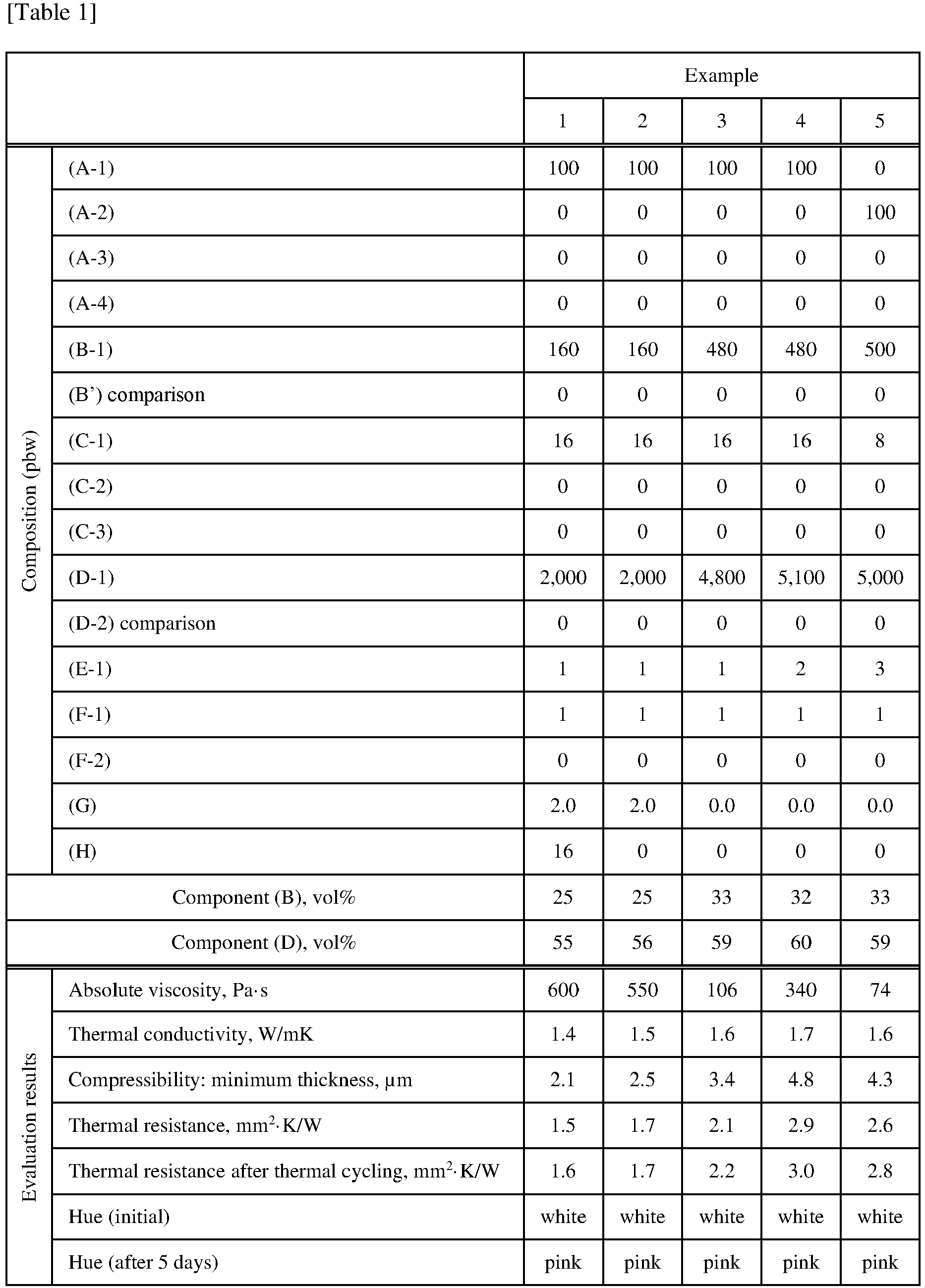

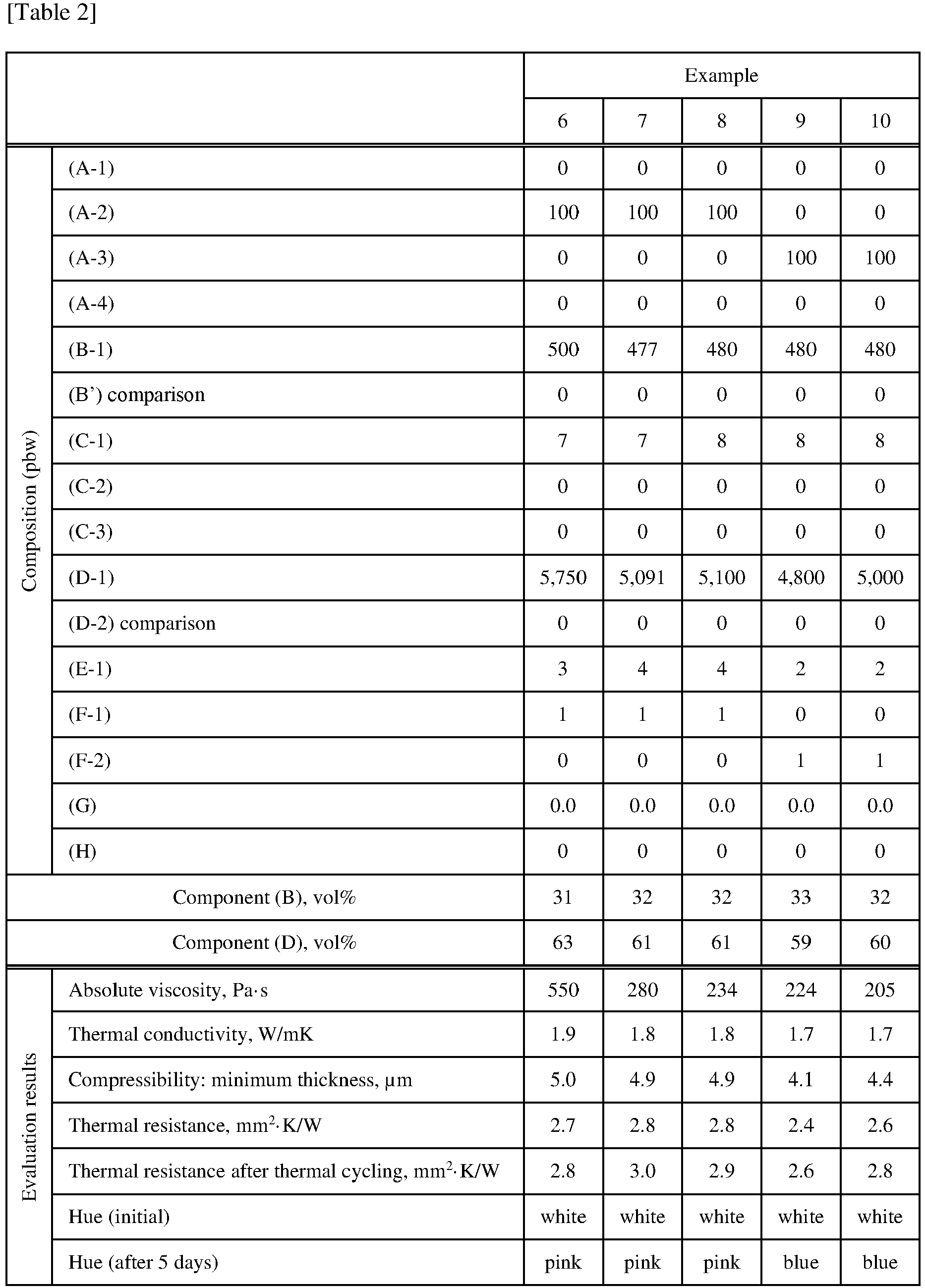

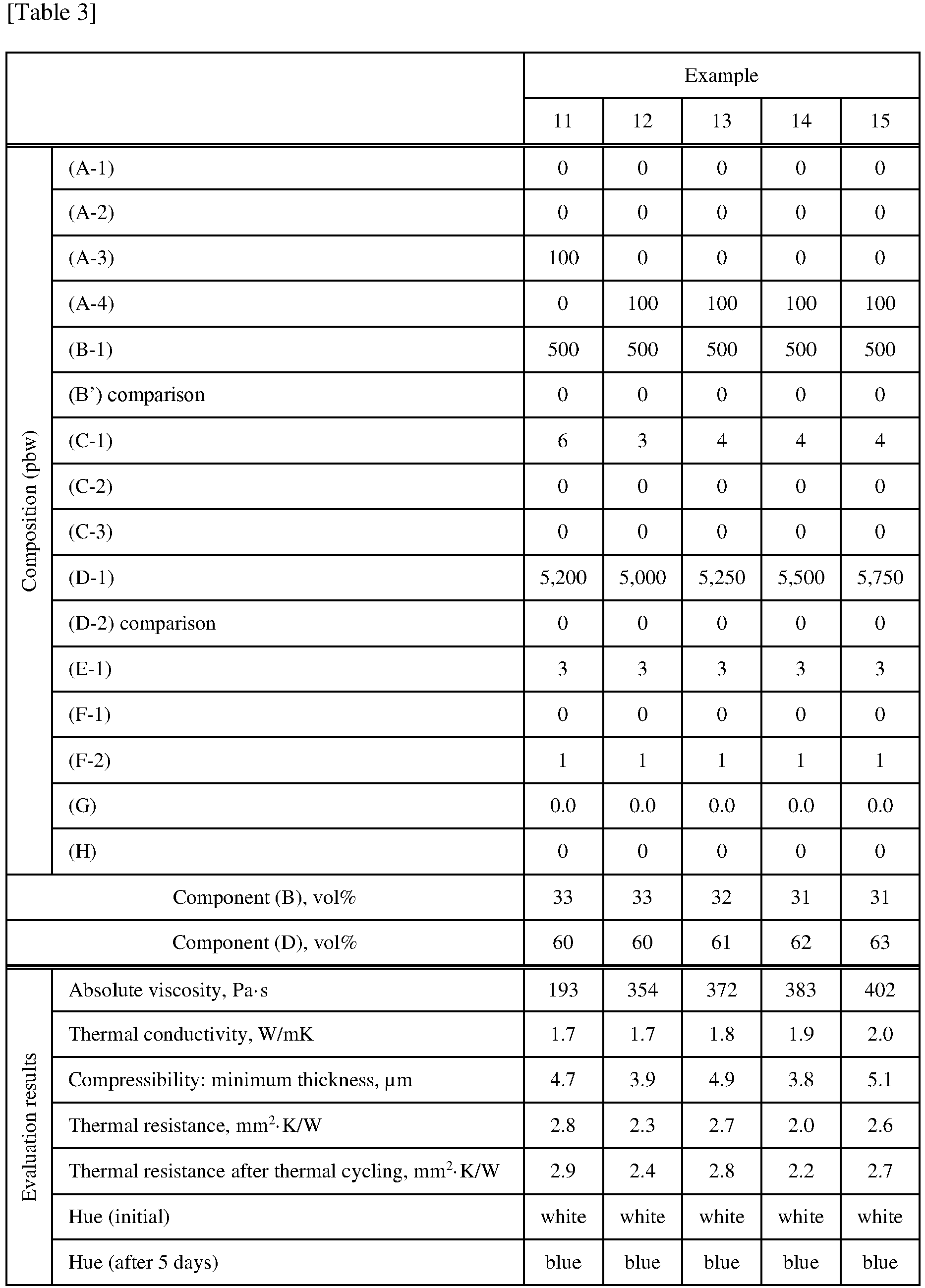

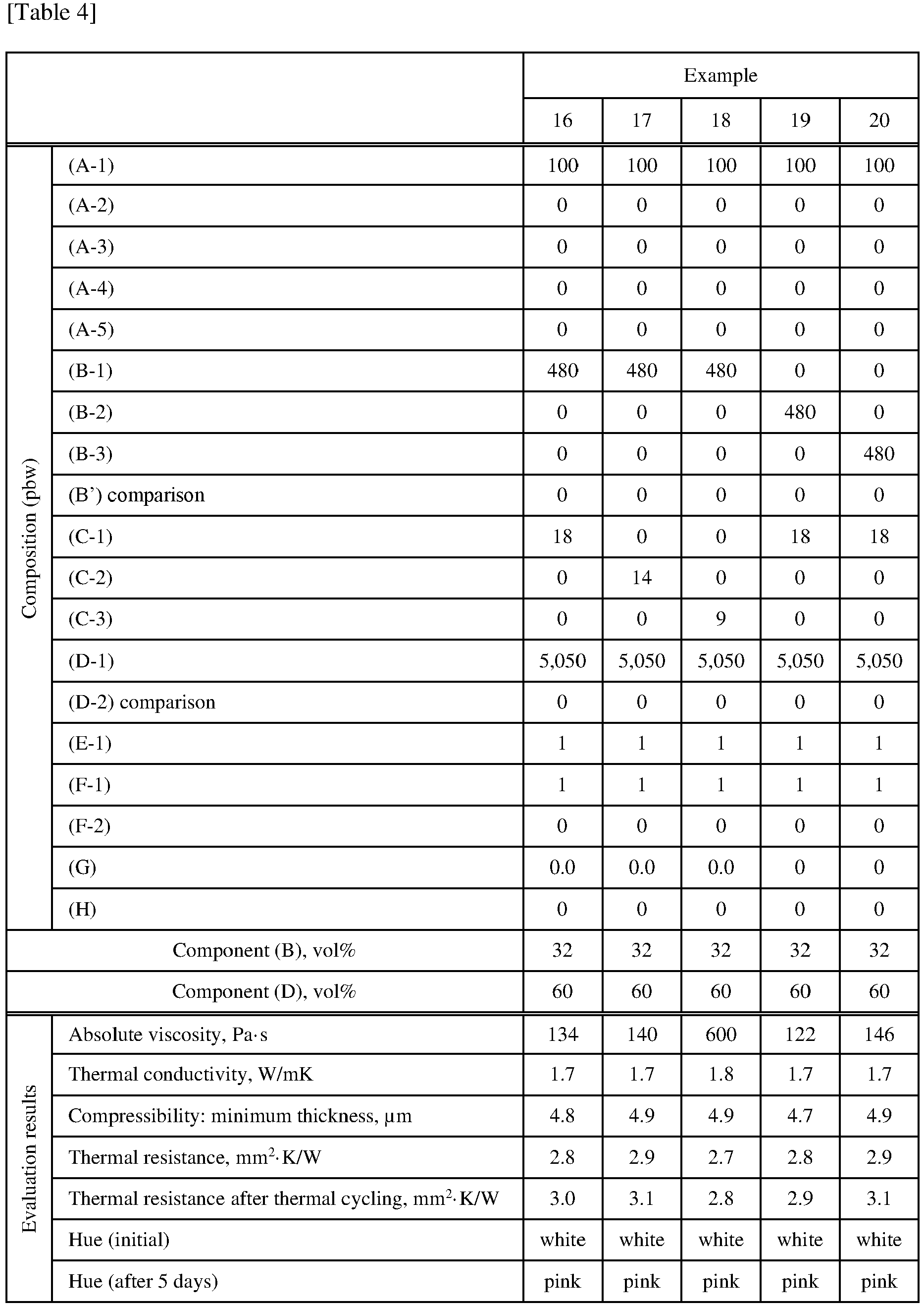

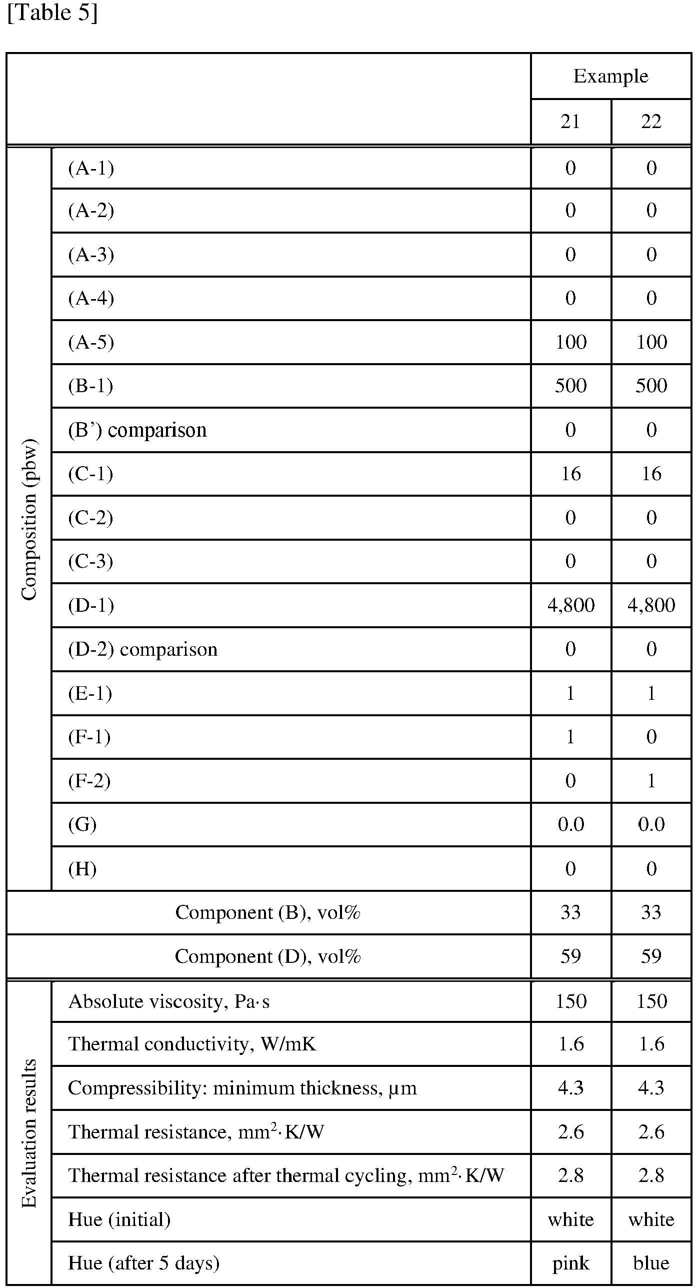

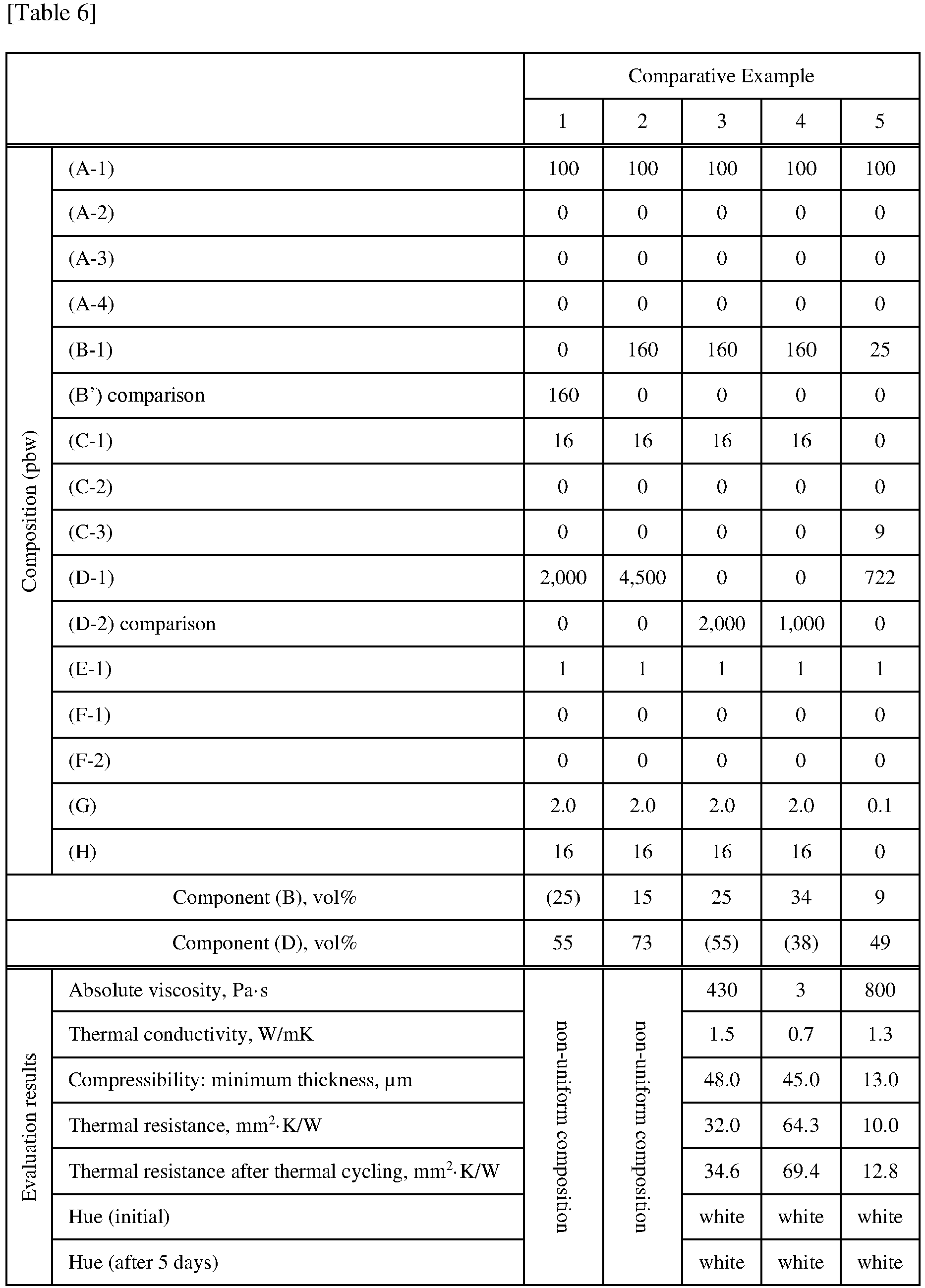

It is evident from the results in Tables 1 to 6 that for the heat conductive silicone compositions of Examples 1 to 22 meeting the requirements of the invention, a high thermal conductivity and satisfactory compressibility to 10 µm or less were shown, and a color change from the initial was acknowledged when the composition was exposed to an atmosphere of 23±2°C and 50±5% RH for 5 days (when crosslinking reaction was complete). In contrast, Comparative Example 1 which does not contain component (F) and does not use component (B) failed to form a uniform heat conductive silicone composition. Comparative Example 2 which does not contain component (F), contains less than 20% by volume of component (B) and more than 70% by volume of heat conductive filler (D) failed to form a uniform heat conductive silicone composition. Comparative Example 3 which does not contain component (F) and uses particulate zinc oxide having an average particle size of 40 µm as the heat conductive filler had a low compressibility and considerably aggravated thermal resistance. Comparative Example 4 which does not contain component (F) and uses particulate zinc oxide having an average particle size of 40 µm as the heat conductive filler, the amount of the heat conductive filler being less than 40% by volume, showed a low compressibility and a considerably reduced thermal conductivity. Comparative Example 5 which does not contain component (F) and contains less amounts of components (B) and (D) had insufficient compressibility and failed to meet the requirements of minimum thickness and thermal conductivity at the same time. With respect to the color change of Comparative Examples 1 to 5 to which the pH indicator (F) is not added, no color change with a lapse of time was observed.

It is noted that the invention is not limited to the aforementioned embodiments. While the embodiments are merely exemplary, any embodiments having substantially the same construction as the technical concept set forth in the following claims and exerting equivalent functions and results are believed to be within the spirit and scope of the invention.

### REFERENCE SIGNS LIST

- 1: heat generating member (IGBT)
- 2: heat conductive silicone composition layer
- 3: cooling member (cooling fin)
- 3a: insulating layer
- 4: cooling water

## Claims

1. A heat conductive silicone composition comprising the following components (A) to (F):
(A) 100 parts by weight of an organopolysiloxane having the general formula (1) or (2): 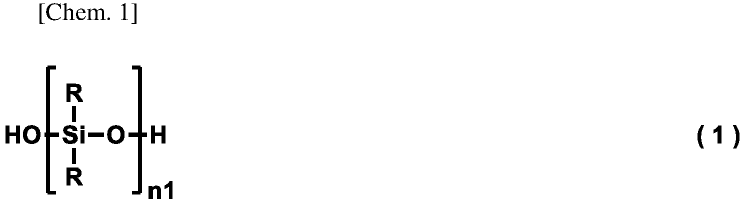 wherein R is independently a C₁-C₂₀ unsubstituted or substituted monovalent hydrocarbon group, and n1 is an integer of at least 10, 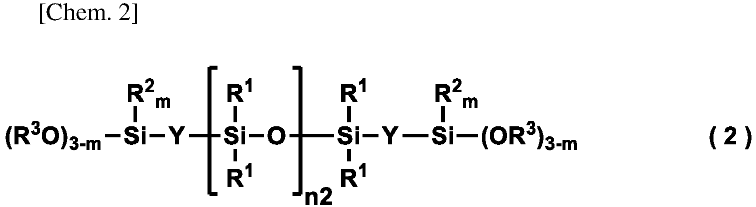 wherein R¹ is independently an unsubstituted or substituted monovalent hydrocarbon group, Y is independently oxygen or a C₁-C₄ alkylene group, R² is independently an unsubstituted or substituted monovalent hydrocarbon group free of aliphatic unsaturation, R³ is independently a C₁-C₄ alkyl, alkoxyalkyl, alkenyl or acyl group, m is an integer of 0 to 2 independently for each of the silicon atoms to which the groups are attached, and n2 is an integer of at least 10,
(B) 150 to 600 parts by weight of an organopolysiloxane having the general formula (3): 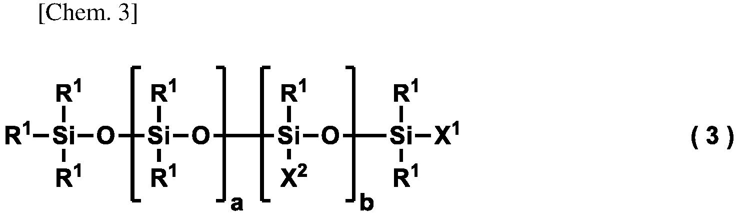 wherein R¹ is independently an unsubstituted or substituted monovalent hydrocarbon group, X¹ is R¹ or a group: -Y-SiR²_{g}(OR³)_{3-g} wherein Y is oxygen or a C₁-C₄ alkylene group, R² is independently an unsubstituted or substituted monovalent hydrocarbon group free of aliphatic unsaturation, R³ is independently a C₁-C₄ alkyl, alkoxyalkyl, alkenyl or acyl group, g is an integer of 0 to 2, X² is independently a group: -Y-SiR²_{g}(OR³)_{3-g} wherein Y, R², R³ and g are as defined for X¹, at least one group: -Y-SiR²_{g}(OR³)_{3-g} being included per molecule, a is an integer of 1 to 1,000, and b is an integer of 0 to 1,000,
(C) 0.1 to 100 parts by weight of a crosslinking agent in the form of a hydrolyzable organosilane compound containing one methyl, vinyl or phenyl group and at least three hydrolyzable groups per molecule and/or a partial hydrolytic condensate thereof,
(D) 1,500 to 6,500 parts by weight of particulate zinc oxide having an average particle size of 0.1 to 2 µm, wherein the content of coarse particles having a particle size of at least 10 µm in the laser diffraction particle size distribution is up to 1% by volume based on the total of component (D),
(E) 0.01 to 30 parts by weight of an adhesion promoter, and
(F) 0.01 to 20 parts by weight of a pH indicator,
the composition having a thermal conductivity of at least 0.5 W/mK as measured at 25°C by the hot disk method.

2. The heat conductive silicone composition of claim 1 which thickens or cures through airborne moisture-aided crosslinking reaction and the composition shows a color change from the color in the unreacted state when the crosslinking reaction is completed.

3. The heat conductive silicone composition of claim 1 or 2 wherein the amount of component (B) is 20 to 40% by volume based on the overall composition, and the composition can be compressed to a thickness of 10 µm or less.

4. The heat conductive silicone composition of any one of claims 1 to 3, further comprising (G) 0.01 to 20 parts by weight of a reaction catalyst per 100 parts by weight of component (A).

5. The heat conductive silicone composition of any one of claims 1 to 4, further comprising (H) 1 to 1,000 parts by weight of a filler other than component (D) per 100 parts by weight of component (A).

6. The heat conductive silicone composition of any one of claims 1 to 5, having a thermal resistance of up to 5 mm²·K/W as measured at 25°C by the laser flash method.

7. The heat conductive silicone composition of any one of claims 1 to 6, having an absolute viscosity of 3 to 600 Pa·s as measured by a spiral viscometer at 25°C and a shear rate of 6 s⁻¹.

8. The heat conductive silicone composition of any one of claims 1 to 7, which is capable of restraining shifting after the thermal cycling test.

9. The heat conductive silicone composition of any one of claims 1 to 8 wherein component (D) is surface-treated with component (B).

10. The heat conductive silicone composition of any one of claims 1 to 9 wherein component (E) is a basic silane coupling agent.

11. The heat conductive silicone composition of any one of claims 1 to 10 wherein component (F) changes its color in the basic region.

12. A method for preparing the heat conductive silicone composition of any one of claims 1 to 11, comprising the step of mixing components (A), (B), (C), (D), (E) and (F).

13. The method for preparing the heat conductive silicone composition according to claim 12, comprising the steps of:
mixing component (B) or components (A) and (B) with component (D) at a temperature of at least 100°C for at least 30 minutes, and
mixing the mixture with at least components (C), (E) and (F).

14. A semiconductor device comprising a heat generating member and a cooling member which define a gap having a thickness of up to 10 µm therebetween, wherein the gap is filled with a layer of the heat conductive silicone composition of any one of claims 1 to 11, and the composition layer thermally intervenes between the heat generating member and the cooling member.

15. The semiconductor device of claim 14 wherein the heat generating member is an insulated gate bipolar transistor.
